# EUROPEAN PATENT APPLICATION

(11) **EP 2 730 334 A1**
(43) Date of publication of application: **14.05.2014**
(21) Application number: 12811322.2
(22) Date of filing: 05.07.2012
(51) Int. Cl.: B01J 35/02, B01J 23/30, B01J 37/02, B32B 9/00

(54) **HYDROPHILIC MEMBER AND METHOD FOR PRODUCING SAME**

(30) Priority: 08.07.2011 JP 2011151987
(71) Applicant: NISSAN MOTOR CO., LTD., Yokohama-shi, Kanagawa 220-8623 (JP)
(72) Inventor: KABURAGI, Tomohiro, Kanagawa 243-0123 (JP); KAI, Yasuaki, Kanagawa 243-0123 (JP); NOGUCHI, Yuji, Kanagawa 243-0123 (JP); OGAWA, Hirosumi, Kanagawa 243-0123 (JP); TSUSHIMA, Kenji, Kanagawa 243-0123 (JP)
(74) Representative: Hoefer & Partner
(86) International application number: PCT/JP2012/067200
(87) International publication number: WO 2013/008718

(57) **Abstract**

Provided is a means which is capable of improving the durability of a hydrophilic member that has a photocatalyst layer containing tungsten oxide. The hydrophilic member includes a substrate, a first intermediate layer which is disposed on the substrate and contains a metal oxide that contains an element of Group 4, Group 6, Group 13 or Group 14 of the periodic table, and a photocatalyst layer which is disposed on the first intermediate layer and contains tungsten oxide.

## Description

### Technical Field

The present invention relates to a hydrophilic member and a method for producing the same. More specifically, the present invention relates to a hydrophilic member desirably used for a window material or a mirror for a building, industrial purposes, an automobile or the like, and a method for producing the same.

### Background Technology

Recently, a photocatalyst capable of adsorbing water or environment polluting materials in air and decomposing and removing those materials when stimulated by sunlight or indoor light receives attention. The photocatalyst has a broad range of applications, and it is desirably used for a windowpane of an automobile, an electric car, an airplane, a ship, or a building, mirror of an automobile, a bathroom, or a curved mirror, an optical lens, or the like.

A member such as glass or mirror to which a photocatalyst is applied is frequently required to have, in addition to an environment purifying function, an anti-fogging · anti-fouling function. In particular, a windowpane, a glass of an automobile, a side mirror, or the like has a problem in that rain or dew condensation by moisture in air causes adhesion of water droplets on a surface and thus visual recognizability is reduced. As such, an anti-fogging/anti-fouling function is given by performing a hydrophilic treatment of the surface, or the like. For example, when the surface of a windowpane, a door mirror of an automobile is hydrophilized, water molecules adsorbed on the surface form an even film, and thus surface fogging is prevented. Further, as the adsorption of environment polluting materials such as exhaust gas from an automobile or the like is suppressed and it is easily washed out by rain or washing even when adhered, the surface can be cleansed.

As a representative photocatalyst, titan oxide exhibiting an excellent catalyst activity is known. However, since titan oxide is a UV-responsive photocatalyst which exhibits its environment purifying action by UV light included in sunlight, sufficient photocatalyst performance is not obtained in an indoor having little UV light. In particular, since the glasses recently used for an automobile or the like are generally a UV-cut type which prevents transmission of UV light, the UV-responsive photocatalyst cannot function in an environment like the inside of an automobile. For such reasons, a photocatalyst exhibiting a catalyst activity by visible light receives attention, and tungsten oxide is known as a representative example thereof.

In Patent Document 1, for example, a method of obtaining a thin film of crystalline tungsten oxide having an excellent visible light-responsive catalyst activity by heating a substrate during sputtering or heating it after sputtering by using gas flow sputtering is described.

### Prior Art Documents

### Patent Document

Patent Document 1: Publication of Japanese Patent Application 2008-106342

### SUMMARY

### Problem to be solved by the invention

However, a tungsten oxide thin film formed on a substrate such as glass as described in Patent Document 1 has a weak structure, and it has a problem of poor durability.

Accordingly, the present invention is intended, with regard to a hydrophilic member having a photocatalyst layer containing tungsten oxide, to provide a means for improving the durability. Means for solving problems

The inventors of the present invention conducted intensive studies to solve the problems described above. As a result, it was found that the above problems can be solved by forming an intermediate layer containing a metal oxide between a substrate and a photocatalyst layer containing tungsten oxide. The present invention is completed accordingly.

Specifically, the hydrophilic member of the present invention has a substrate, a first intermediate layer which is disposed on the substrate and contains a metal oxide that contains an element of Group 4, Group 6, Group 13 or Group 14 of the periodic table, and a photocatalyst layer which is disposed on the first intermediate layer and contains tungsten oxide.

### Effect of the invention

According to the present invention, a photocatalyst layer containing tungsten oxide is formed on an intermediate layer so that the photocatalyst layer becomes a dense film with excellent mechanical strength, and thus a hydrophilic member having improved durability is obtained.

### Brief descriptions of drawings

Fig. 1A is a schematic cross-sectional view illustrating the basic configuration of a hydrophilic member according to an embodiment of the present invention.
Fig. 1B is a schematic cross-sectional view illustrating the basic configuration of a hydrophilic member according to the embodiment of the present invention.
Fig. 1C is a schematic cross-sectional view illustrating the basic configuration of a hydrophilic member according to the embodiment of the present invention.
Fig. 1D is a schematic cross-sectional view illustrating the basic configuration of a hydrophilic member according to the embodiment of the present invention.
Fig. 1E is a schematic cross-sectional view illustrating the basic configuration of a hydrophilic member according to the embodiment of the present invention.
Fig. 1F is a schematic cross-sectional view illustrating the basic configuration of a hydrophilic member according to the embodiment of the present invention.
Fig. 1G is a schematic cross-sectional view illustrating the basic configuration of a hydrophilic member according to the embodiment of the present invention.
Fig. 1H is a schematic cross-sectional view illustrating the basic configuration of a hydrophilic member according to the embodiment of the present invention.
Fig. 1I is a schematic cross-sectional view illustrating the basic configuration of a hydrophilic member according to the embodiment of the present invention.
Fig. 2 is a diagram illustrating the relation between a thickness of a tungsten oxide layer and reflectance.
Fig. 3 is a diagram illustrating the Raman spectrum of members for evaluation that have been obtained from Example 1 and Comparative Example 1.
Fig. 4 is a diagram illustrating the relation between time for calcining a tungsten oxide film and a contact angle on the surface of the tungsten oxide film after the calcination.
Fig. 5A is a diagram illustrating the SEM photograph of the surface of a photocatalyst layer of a member for evaluation that has been produced in Example 1.
Fig. 5B is a diagram illustrating the SEM photograph of the surface of a photocatalyst layer of a member for evaluation that has been produced in Example 2.
Fig. 5C is a diagram illustrating the SEM photograph of the surface of a photocatalyst layer of a member for evaluation that has been produced in Comparative Example 1.

### Mode for carrying out the invention

Hereinbelow, the embodiments of the present invention will be described in view of the drawings attached hereto. However, the present invention is not limited to the following embodiments. A dimension ratio in the drawings is somewhat exaggerated for the sake of convenience of explanation, and it may be different from an actual ratio.

According to one embodiment of the present invention, a hydrophilic member having a substrate, a first intermediate layer which is disposed on the substrate and contains a metal oxide that contains an element of Group 4, Group 6, Group 13 or Group 14 of the periodic table, and a photocatalyst layer which is disposed on the first intermediate layer and contains tungsten oxide is provided.

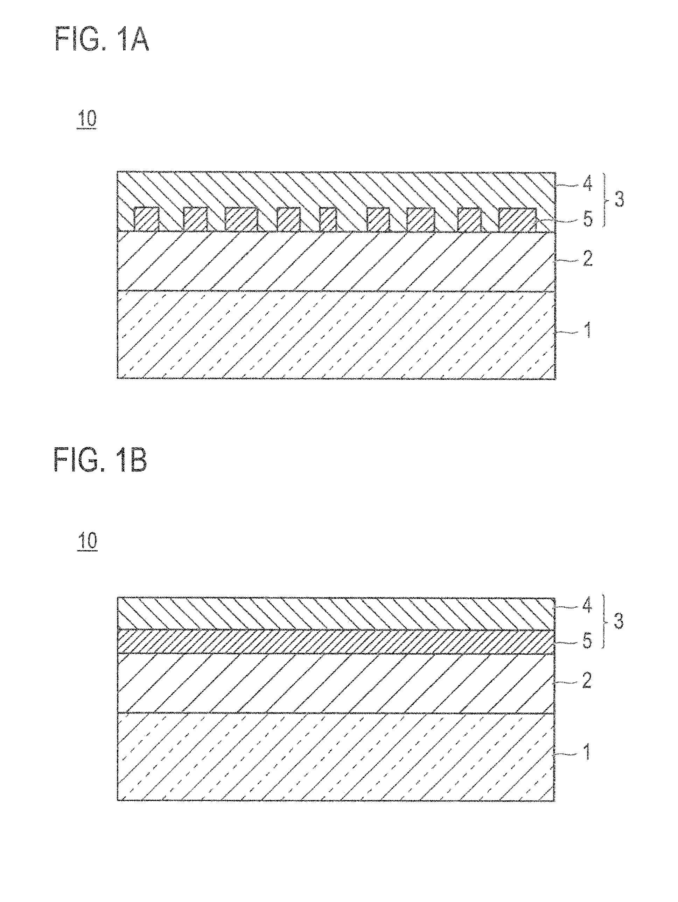

Figs. 1A to 1I are schematic cross-sectional views illustrating the basic configuration of a hydrophilic member according to one embodiment of the present invention. Hereinbelow, the embodiment of the hydrophilic member will be described in view of Figs. 1A to 1I.

Fig. 1A is a schematic cross-sectional view illustrating the basic configuration of a hydrophilic member according to one embodiment of the present invention. As illustrated in Fig. 1A, the hydrophilic member 10 is configured such that a first intermediate layer 2 and a photocatalyst layer 3 are laminated in the order on a substrate 1.

The first intermediate layer 2 is formed on a substrate and is constituted by containing a metal oxide.

The photocatalyst layer 3 is constituted with a tungsten oxide layer 4 containing tungsten oxide and a catalyst activity promoting layer 5 containing a catalyst activity promoting agent (for example, CuO). In the present embodiment, the catalyst activity promoting layer 5 is partially formed on top of the substrate 1. Specifically, the hydrophilic member 10 of the present embodiment has a lamination structure including the first intermediate layer 2 disposed on the substrate 1, the catalyst activity promoting layer 5 partially disposed on top of the first intermediate layer 2, and the tungsten oxide layer 4 disposed on top of the first intermediate layer 2 to cover the catalyst activity promoting layer 5. Such structure with partially formed catalyst activity promoting layer 5 is preferable in that a decrease in transparency caused by a catalyst activity promoting agent for constituting the catalyst activity promoting layer is suppressed.

However, the catalyst activity promoting layer 5 can be formed on the entire top surface of the first intermediate layer 2. For example, as illustrated in Fig. 1B, the hydrophilic member 10 may have a structure in which, on the substrate 1, the first intermediate layer 2, the catalyst activity promoting layer 5, and the tungsten oxide layer 4 are laminated in the order.

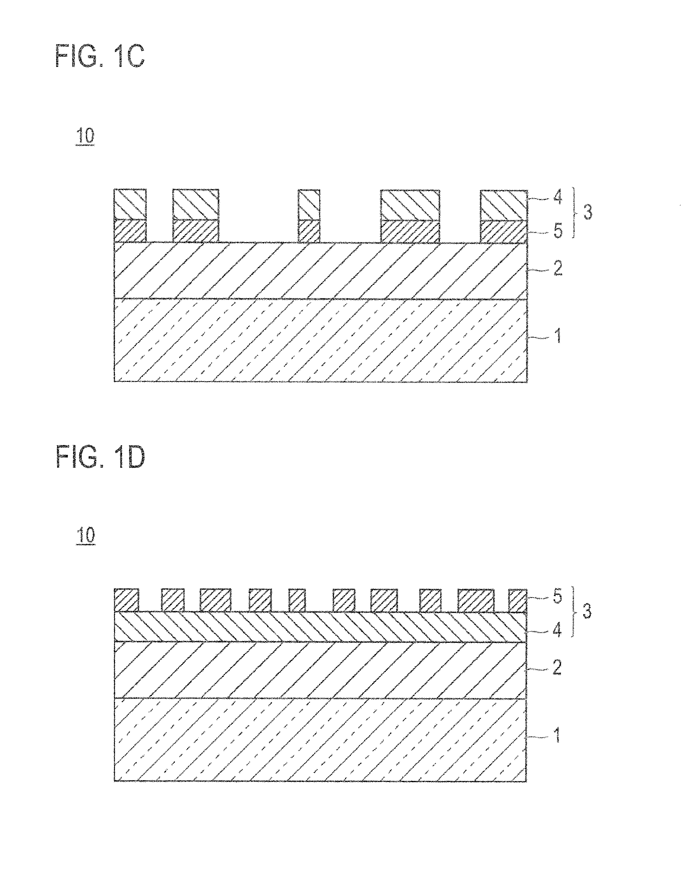

Fig. 1C is a schematic cross-sectional view illustrating the basic configuration of a hydrophilic member according to another embodiment of the present invention. In the embodiment, the tungsten oxide layer 3 is also partially formed on the first intermediate layer 2, in addition to the catalyst activity promoting layer 5. According to this embodiment, the amount of tungsten oxide can be reduced, and thus it is advantageous in terms of cost.

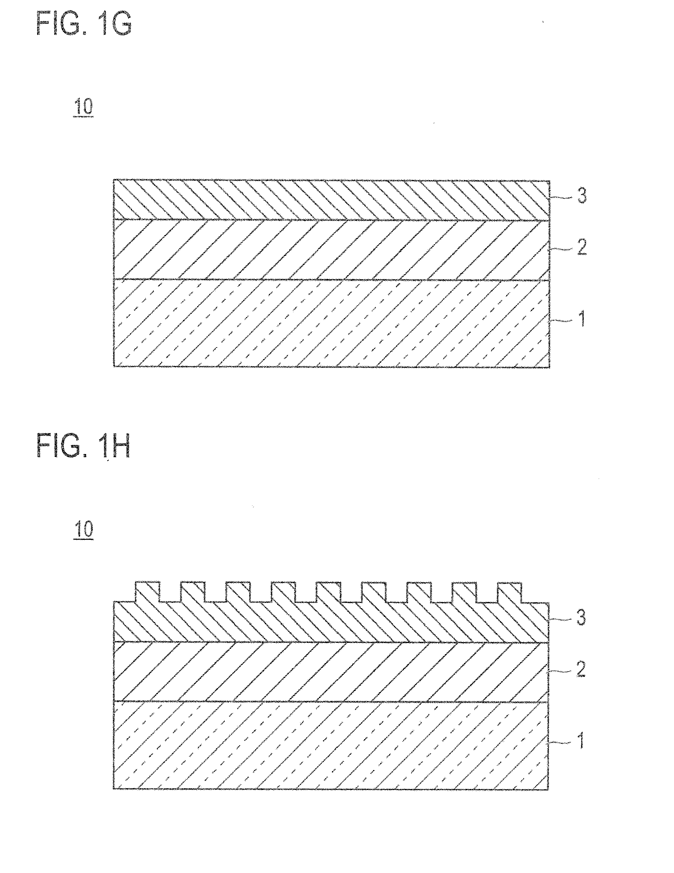

When the catalyst activity promoting layer 5 is present below the tungsten oxide layer 4 as illustrated in Figs. 1A to 1C and Fig. 1H to be described below, it is difficult to be affected by light absorption by the catalyst activity promoting agent, which constitutes the catalyst activity promoting layer 5. In particular, when a catalyst activity promoting agent having excellent light absorption properties such as CuO is present on top of the tungsten oxide layer 4, light absorption by the tungsten oxide, which exhibits a photocatalytic activity, may be impaired. Thus, disposing the catalyst activity promoting layer 5 below the tungsten oxide layer 4 is preferable in that the light absorption by the catalyst activity promoting agent can be suppressed.

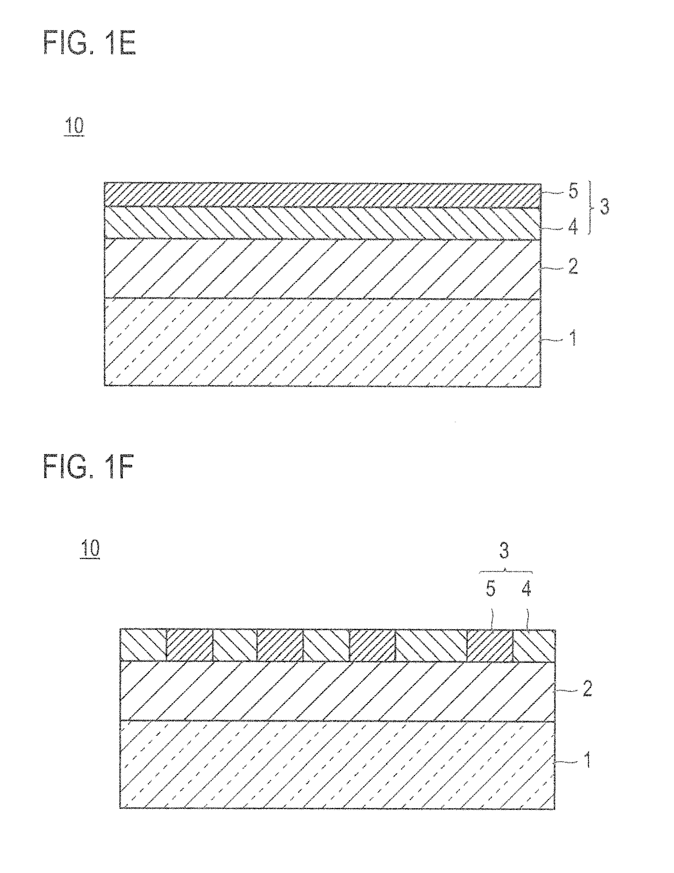

In Figs. 1A to 1C, and Fig. 1H, the catalyst activity promoting layer 5 is formed below the tungsten oxide layer 4. However, the present invention is not limited to such mode and, as illustrated in Fig. 1D, the catalyst activity promoting layer 5 may be formed on top of the tungsten oxide layer 4. In the present embodiment, the catalyst activity promoting layer 5 is partially formed on top of the tungsten oxide layer 4. Meanwhile, as illustrated in Fig. 1E, the catalyst activity promoting layer 5 may be formed on the entire top surface of the tungsten oxide layer 4.

Fig. 1F is a schematic cross-sectional view illustrating the basic configuration of a hydrophilic member according to another embodiment of the present invention. As illustrated in Fig. 1F, it is possible to have a configuration that the catalyst activity promoting layer 5 is formed on a part of the top surface of the first intermediate layer 2 and the tungsten oxide layer 4 is formed on the remaining area. In such case, as the tungsten oxide layer 4 and the catalyst activity promoting layer 5 are adjacent to each other, an intermediate product produced by photodegradation can be quickly supplied, and therefore desirable.

According to the modes of Figs. 1A to 1F described above, and Fig. 1H to be described below, the tungsten oxide layer 4 and the catalyst activity promoting layer 5 are formed as a separate body in the photocatalyst layer 3. However, the photocatalyst layer of the present invention is not limited to such mode.

For example, as illustrated in Fig. 1G and Fig. 1H, the photocatalyst layer 3 in monolayer form can be also preferably used. When the photocatalyst layer 3 has monolayer form, the photocatalyst layer 3 may be either a monolayer film consisting of tungsten oxide or a monolayer film consisting of the catalyst activity promoting agent and/or other additives in addition to tungsten oxide.

When the photocatalyst layer 3 is prepared as a monolayer film containing the catalyst activity promoting agent or the like in addition to tungsten oxide, it may consist of a mixture powder including tungsten oxide powder (microparticles) and the catalyst activity promoting agent powder (microparticles) or it may consist of a supported body produced by supporting the catalyst activity promoting agent (fine powder) on tungsten oxide powder.

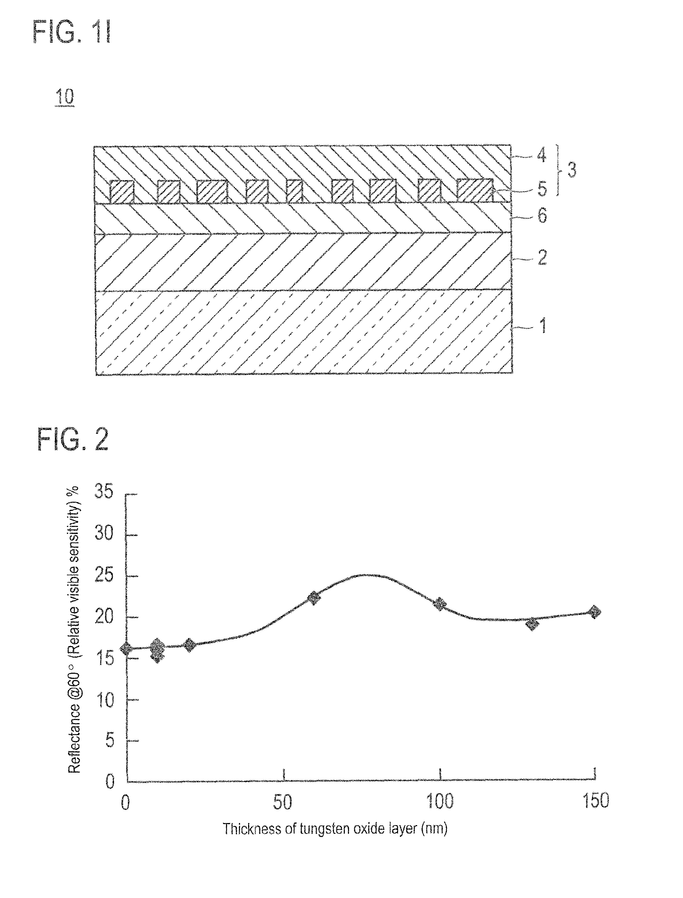

In Figs. 1A to 1H, the photocatalyst layer 3 is formed right above the first intermediate layer 2, but the present invention is not limited to such mode. For example, as illustrated in Fig. 1I, a second intermediate layer 6 containing a metal oxide and tungsten oxide may be disposed between the first intermediate layer 2 and the photocatalyst layer 3. Specifically, the intermediate layer inserted between the photocatalyst layer 3 and the substrate 1 may have laminate form having the first intermediate layer 2 and the second intermediate layer 6. The second intermediate layer 6 containing a metal oxide and tungsten oxide may function as an interface buffer layer between the first intermediate layer 2 containing a metal oxide and the photocatalyst layer 3 containing tungsten oxide. By having such configuration, an increase in haze ratio derived from light reflection on an interface between the photocatalyst layer 3 and the first intermediate layer 2 can be suppressed. Meanwhile, Fig. 1I exhibits a state in which the second intermediate layer 6 is formed between the first intermediate layer 2 and the photocatalyst layer 3 of the state illustrated in Fig. 1A. According to the present invention, for other modes described above, for example, the modes illustrated in Figs. 1B to 1H, the second intermediate layer 6 can be similarly formed between the first intermediate layer 2 and the photocatalyst layer 3.

A shape of the surface of the photocatalyst layer 3 is not particularly limited. As illustrated in Fig. 1A, Fig. 1B, Figs. 1E to 1G, and Fig. 1I, it may have a smooth surface, or as illustrated in Fig. 1C, Fig. 1D, and Fig. 1H, it may have irregularities formed thereon.

According to the mode illustrated in Figs. 1A to 1D and Figs. 1F to 1I, tungsten oxide (tungsten oxide layer 4) is present on the outermost surface of the photocatalyst layer 3. Meanwhile, the catalyst activity promoting agent for constituting the catalyst activity promoting layer 5 has low hydrophilicity by itself. For such reasons, it is unnecessary to expose the catalyst activity promoting agent itself on the surface. Instead, for exhibiting excellent hydrophilicity, it is desirable to dispose tungsten oxide with hydrophilic surface on the outermost surface of the photocatalyst layer 3.

According to a more preferred mode, the catalyst activity promoting agent is present within the photocatalyst layer 3 while the catalyst activity promoting agent is not present on the outermost surface of the photocatalyst layer 3 (Figs. 1A to C, and Fig. 1I). According to an even more preferred mode, only the tungsten oxide is present on the outermost surface of the photocatalyst layer 3 (Fig. 1A, Fig. 1B, and Fig. 1I).

For the modes illustrated in Fig. 1A, Fig. 1C, Fig. 1D, Fig. 1F, or Fig. 1I, the arrangement of the tungsten oxide layer 4 or the catalyst activity promoting agent layer 5, that are partially formed, is not particularly limited, and it may be either regular or irregular. Further, the cross-sectional shape of the catalyst activity promoting agent layer 5 is not also particularly limited, and any shape such as circular shape, elliptical shape, square shape, rectangular shape, approximate circular shape, polygonal shape, or indefinite shape can be adopted. A size of the catalyst activity promoting agent layer 5 is not limited at all as long as the tungsten oxide layer 2 and the catalyst activity promoting layer 5 cooperate with each other for functioning. However, it is preferably 10 µm to 50 mm, and more preferably about 100 µm to 5 mm.

Meanwhile, in the modes illustrated in Figs. 1A to 1I, other layer may be inserted between the substrate 1 and the first intermediate layer 2. It is also possible that other layer may be disposed between the first intermediate layer 2 or the second intermediate layer 6 and the photocatalyst layer 3, either in addition to it or instead of it. However, from the viewpoint of improving the adhesiveness between the substrate 1 and the photocatalyst layer 3, it is preferable that the intermediate layer

(first intermediate layer or second intermediate layer) and the photocatalyst layer are in contact with each other. Specifically, the photocatalyst layer is preferably disposed right above the intermediate layer (first intermediate layer or second intermediate layer). Although not particularly limited, examples of a layer which can be inserted include a layer for preventing deterioration of a substrate surface by a photocatalytic activity (for example, layer using Teflon (registered trademark) resin or the like).

Hereinbelow, the member for constituting the hydrophilic member 1 will be described.

### (Substrate)

Materials for constituting the substrate 1 are not particularly limited, and examples thereof include glass such as soda glass (soda lime glass), lead glass (crystal glass), borosilicate glass, or conductive glass such as ITO glass or FTO glass; a resin such as acrylic resin, polystyrene, ABS, polyethylene, polypropylene, polyethylene terephthalate, polyethylene naphthalate, polyamide resin, polyvinyl chloride resin, polycarbonate resin, polyphenylene sulfide resin, polyphenylene ether resin, polyimide resin, or cellulose resin; mirror; lens; metal; ceramic; rock; cement; concrete; and a combination thereof. It is preferably glass which can effectively exhibit an anti-fogging function/anti-fouling function.

A shape of the substrate is not particularly limited, either. As long as it can form a photocatalyst layer, it may have any shape. It may be a porous body. A thickness of the substrate is, although not particularly limited, generally about 1 to 10 mm.

### (Intermediate layer; first intermediate layer and second intermediate layer)

The first intermediate layer 2 is disposed on the substrate 1 and is constituted by containing a metal oxide. The first intermediate layer 2 is inserted between the substrate 1 and the photocatalyst layer 3 and has a property of enhancing adhesiveness between the substrate 1 and the photocatalyst layer 3. Further, when the photocatalyst layer 3 is in contact with the substrate 1, the surface of the substrate 1 may easily get deteriorated due to a photocatalytic action of the photocatalyst layer 3. According to the present invention, the first intermediate layer 2 is inserted between the substrate 1 and the photocatalyst layer 3, and thus deterioration of the surface of the substrate 1 can be also prevented.

The metal oxide for constituting the first intermediate layer is not particularly limited as long as it can provide the adhesiveness. Specific examples thereof include an oxide containing an element of Group 4, Group 6, Group 13, or Group 14 of the periodic table. Preferred examples include an oxide containing an element of Group 4 of the periodic table such as Ti, Zr, or Nf, an element of Group 6 such as Cr, Mo, or W, an element of Group 13 such as Al, Ga, or In, and an element of Group 14 such as Si, Ge, Sn, or Pb. Among them, particularly preferred is at least one selected from a group consisting of silicon oxide (SiO₂), titan oxide (TiO₂), aluminum oxide (Al₂O₃), tin oxide (SnO₂), and tungsten oxide (WO₃). Meanwhile, in no case the first intermediate layer consists of tungsten oxide (WO₃) only. In other words, the first intermediate layer contains a metal oxide other than tungsten oxide. When the first intermediate layer consists of at least one selected from a group consisting of silicon oxide (SiO₂), titan oxide (TiO₂), aluminum oxide (Al₂O₃), tin oxide (SnO₂), and tungsten oxide (WO₃), tungsten oxide (WO₃) formed on the first intermediate layer has a monoclinic (that is, monoclinic) structure, and thus it can exhibit excellent photocatalyst performance. Particularly preferably, the first intermediate layer is formed with silicon oxide (SiO₂). Titan oxide (TiO₂), aluminum oxide (Al₂O₃), and tin oxide (SnO₂) have higher refractive index than soda glass, but silicon oxide (SiO₂) has refractive index similar to that of soda glass. As such, a hydrophilic member using silicon oxide (SiO₂) has about the same reflectance as the substrate, and even when the hydrophilic member 10 is applied to a wind shield of an automobile, image projection or the like can be prevented. The metal oxide for constituting the first intermediate layer may be any one of amorphous or crystalline. The metal oxide for constituting the first intermediate layer may be used either singly or in combination of two or more types.

A thickness of the first intermediate layer is not particularly limited, and it can be suitably adjusted depending on the type of metal oxide in consideration of properties such as adhesion property or transparency and cost. It is generally 10 nm to 10 µm. For exhibiting sufficient adhesiveness, the thickness is preferably 20 nm or more, and is more preferably 50 nm or more for enhancing the crystallinity of the photocatalyst layer formed on the top. Further, when the intermediate layer is formed by sputtering to be described below, it is preferably 100 nm or less from the viewpoint of cost. When it is formed by a sol-gel method, it is preferably 2 µm or less from the viewpoint of the thickness obtained by single film formation (0.1 µm per each time).

If necessary, the second intermediate layer 6 is disposed between the first intermediate layer 2 and the photocatalyst layer 3. The second intermediate layer 6 is formed by containing a metal oxide and tungsten oxide. The second intermediate layer 6 functions as an interface buffer layer between the first intermediate layer 2 containing a metal oxide and the photocatalyst layer 3 containing tungsten oxide, and plays a role of suppressing an increase in a haze ratio which is derived from light reflection on an interface between the photocatalyst layer 3 and the first intermediate layer 2. Also, the hydrophilicity and durability can be further improved when the second intermediate layer 6 is included.

As for the tungsten oxide constituting the second intermediate layer, the same tungsten oxide as that of the photocatalyst layer 3 to be described below can be used. Preferably, it has the same crystal structure of the tungsten oxide as that of the tungsten oxide which constitutes the photocatalyst layer 3. Adhesiveness to the photocatalyst layer 3 disposed right above the second intermediate layer can be improved in such case. Further, the effect of lowering light reflection on an interface between the photocatalyst layer 3 and the first intermediate layer 2 can be also enhanced, and thus the increase in a haze ratio can be further suppressed.

The metal oxide for constituting the second intermediate layer is not particularly limited as long as it can exhibit an interface buffering function. Specific examples thereof include an oxide containing an element of Group 4, Group 6, Group 13, or Group 14 of the periodic table. Preferred examples include an oxide containing an element of Group 4 of the periodic table such as Ti, Zr, or Nf, an element of Group 6 such as Cr, Mo, or W, an element of Group 13 such as Al, Ga, or In, and an element of Group 14 such as Si, Ge, Sn, or Pb. Meanwhile, in no case the second intermediate layer consists of tungsten oxide (WO₃) only. In other words, the second intermediate layer contains a metal oxide other than tungsten oxide. More preferred is at least one selected from a group consisting of silicon oxide (SiO₂), titan oxide (TiO₂), aluminum oxide (Al₂O₃), and tin oxide (SnO₂). When the second intermediate layer is a mixture layer of tungsten oxide and at least one selected from a group consisting of silicon oxide (SiO₂), titan oxide (TiO₂), aluminum oxide (Al₂O₃), and tin oxide (SnO₂), tungsten oxide (WO₃) formed on the second intermediate layer has a monoclinic (that is, monoclinic) structure, and thus can exhibit excellent photocatalyst performance. Particularly preferably, the metal oxide constituting the second intermediate layer is silicon oxide (SiO₂). Titan oxide (TiO₂), aluminum oxide (Al₂O₃) and tin oxide (SnO₂) have higher refractive index than soda glass, but silicon oxide (SiO₂) has refractive index similar to that of soda glass. As such, by forming the second intermediate layer with silicon oxide (SiO₂) and tungsten oxide, the refractive index can be gradually changed from the substrate 1 to the photocatalyst layer 3, and even when the hydrophilic member 10 is applied to a wind shield of an automobile, image projection or the like can be prevented. The metal oxide for constituting the second intermediate layer may be any one of amorphous or crystalline. The metal oxide for constituting the second intermediate layer may be used either singly or in combination of two or more types.

A thickness of the second intermediate layer is not particularly limited, and can be suitably adjusted depending on the type of metal oxide in consideration of properties such as adhesion property or transparency and cost. It is generally 5 nm to 10 µm. For exhibiting a sufficient interface buffering activity (effect of suppressing an increase in haze ratio) (volume ratio), the thickness is preferably 10 nm or more. Further, when the intermediate layer is formed by sputtering to be described below, it is preferably 100 nm or less from the viewpoint of cost. When it is formed by a sol-gel method, it is preferably 2 µm or less from the viewpoint of the thickness obtained by single film formation (0.1 µm per each time).

A blending ratio between the metal oxide and tungsten oxide (metal oxide/tungsten oxide) in the second intermediate layer is, although not particularly limited, preferably 30/70 to 90/10. Since a metal oxide such as silicon oxide often has the same optical properties as those of a substrate, the amount of the metal oxide can be high if it is within a range in which the effect of suppressing the increase in haze ratio caused by tungsten oxide is obtained. From such point of view, it is sufficient that the blending ratio (metal oxide/tungsten oxide) is 90/10 or less. Meanwhile, since the refractive index of tungsten oxide is significantly different from that of a substrate, an excessively large blending amount of tungsten oxide is not preferable. As such, the blending ratio is preferably 30/70 or more.

Meanwhile, the metal oxide constituting the first intermediate layer and the metal oxide constituting the second intermediate layer may be the same or different from each other. Preferably, at least one of the metal oxide constituting the second intermediate layer is the same as at least one of the metal oxide constituting the first intermediate layer. More preferably, the entire metal oxides constituting the second intermediate layer are the same as the entire metal oxides constituting the first intermediate layer. In such case, the effect of suppressing light reflection on an interface between the photocatalyst layer 3 and the first intermediate layer 2 is improved so that the increase in haze ratio can be further suppressed.

It is also possible that an additional intermediate layer (a third intermediate layer) may be formed between the first intermediate layer and the second intermediate layer. The third intermediate layer may be a layer containing the metal oxide described above, or a layer in which tungsten oxide and the metal oxide described above are mixed.

### (Photocatalyst layer)

The photocatalyst layer 3 is disposed on the intermediate layer 2, and is constituted by containing tungsten oxide, and if necessary, a catalyst activity promoting agent or other additives. Since the photocatalyst layer 3 contains tungsten oxide, which is a visible ray responsive photocatalyst, it suppresses adhesion of environment polluting materials by the photocatalytic action, and thus can exhibit an anti-fouling function. Further, since a surface of the photocatalyst layer 3 has excellent hydrophilicity, it can exhibit an anti-fogging function for preventing cloudiness even when applied with water droplets.

As described herein, the term "hydrophilicity" means a state of having high water wettability, and it indicates that the contact angle between a surface of the photocatalyst layer and water is 20° or less, and preferably 10° or less. Further, the term "super-hydrophilicity" indicates that the contact angle between a surface of the photocatalyst layer and water is 7° or less. Particularly preferably, it has super-hydrophilicity in which the contact angle between a surface of the photocatalyst layer and water is 5° or less. By having such hydrophilicity, water droplets adhered on the surface are evenly spread so that fogging of glass, mirror, or the like or lower transmission caused by moisture is prevented, and thus good visibility is ensured even in the rain. Meanwhile, as for the contact angle, the values measured by a θ/2 method using a commercially available apparatus for measuring contact angle are used.

In general, when hydrophilicity is exhibited in accordance with production of a hydroxyl group on a surface, polluting materials such as dirt or organic substances in the air get easily adhered, and thus, there are many cases that the hydrophilic property is decreased with the passage of time. However, with the photocatalyst layer containing tungsten oxide according to the present invention, the adhered polluting materials are degraded due to a photocatalytic function of tungsten oxide, or even further due to a photocatalytic function of a catalyst activity promoting agent, and thus the deterioration of the hydrophilic property is prevented and the hydrophilicity can be maintained for a long period of time.

In the present invention, the photocatalyst layer 3 is formed on the intermediate layer 2 consisting of a metal oxide. Accordingly, the photocatalyst layer 3 to be formed becomes a strong and dense layer so that the durability can be improved.

In a case in which a photocatalyst layer (tungsten oxide film) is directly formed on a substrate like a hydrophilic member of the related art (for example, Patent Document 1), the surface of the photocatalyst layer is peeled off to yield an easily breakable weak structure, and thus there is a problem that the durability is poor. However, in the present invention, the photocatalyst layer 3 is formed on the intermediate layer 2 so that a strong hydrophilic surface is obtained.

More preferably, the photocatalyst layer 3 has a dense porous structure. When it has a porous structure, environment polluting materials or visible light can easily permeate through the inside, and thus the catalytic activity and utilization efficiency can be increased. As described herein, the term "porous" means that there are numerous continuous or non-continuous pores. A shape or a structure of a porous body is not particularly limited. It can have various forms such as a three-dimensional web form, a honeycomb form, a sponge form, or the like. From this point of view, the photocatalyst layer 3 preferably consists of tungsten oxide or microparticles of a catalyst activity promoting agent. Particle diameter of tungsten oxide is preferably 0.2 nm to 100 µm, or more preferably 10 nm to 100 µm. Particle diameter of the catalyst activity promoting agent is preferably 0.2 nm to 100 µm. Within the range, a film can be easily formed and a dense film having high binding property is obtained. However, it is not limited to the above range at all, and it is possible to mix particles with plural particle diameters. It can be also secondary particles in which primary particles are aggregated. It can be also a supported body obtained by supporting the catalyst activity promoting agent (fine powders) on a powder of tungsten oxide described above. Meanwhile, as for the particle diameter of tungsten oxide or the catalyst activity promoting agent, median diameter obtained by laser diffraction method can be used. Further, a shape of these particles varies depending on the type or production method. Examples thereof include a spherical shape (powder shape), a plate shape, a needle shape, a column shape, and a prism shape, but it is not limited thereto, and any shape can be used without a problem.

As illustrated in Figs. 1A to 1F, and Fig. 1I, tungsten oxide is generally molded into a film shape and forms the tungsten oxide layer 4.

When the photocatalyst layer 3 contains a catalyst activity promoting agent or other additives, tungsten oxide and the catalyst activity promoting agent or the like may be present as a separate body (different layers). For example, it is possible that the catalyst activity promoting agent or the like is formed to be a thin film (catalyst activity promoting layer 5) and laminated on the tungsten oxide layer 4 (Figs. 1A to 1E, and Fig. 1I), or placed adjacent to the tungsten oxide layer 4 (Fig. 1A and Fig. 1F). Alternatively, by mixing or supporting tungsten oxide and the catalyst activity promoting agent, they can be present in a single layer (for example, Fig. 1H and Fig. 1G).

When the photocatalyst layer 3 contains a catalyst activity promoting agent, the catalyst activity promoting agent is preferably brought into contact with tungsten oxide so that the catalyst activity promoting effect of a photocatalyst and the effect of enhancing hydrophilicity are sufficiently exhibited. For example, it is preferable to have a structure in which the tungsten oxide layer 4 is in contact with the catalyst activity promoting layer 5 (Figs. 1A to 1F, and Fig. 1I) or a monolayer structure containing tungsten oxide and the catalyst activity promoting agent (Fig. 1G and Fig. 1H), and to have tungsten oxide and the catalyst activity promoting agent co-exist in the same region. However, the present invention is not limited to such an embodiment, and even when they are separated but present in the neighborhood, the effect of enhancing the hydrophilicity or the photocatalytic effect is fully expected. For example, by having both the catalyst activity promoting agent and tungsten oxide co-exist by arranging them in a separate area on the intermediate layer (first intermediate layer 2 or second intermediate layer 6) and allowing them to function as a unit, the photocatalyst layer 3 in non-contact state can be produced.

Thickness of the photocatalyst layer 3 is not particularly limited, and it can be suitably adjusted by considering the hydrophilic property or strength and transparency of the film. Meanwhile, for a case in which a photocatalyst layer has a multi-layer form, total thickness of each layer is taken as the thickness of the photocatalyst layer. Thickness of the photocatalyst layer is generally 10 nm to 10 µm. However, when a transparent substrate like glass is used as the substrate 1, it is preferable that the photocatalyst layer 3 also has excellent transparency, and the film thickness is preferably reduced until the color hue is not distinct. From this point of view, thickness of the photocatalyst layer is preferably 10 nm to 1 µm.

In the case of the multi-layer form, thickness of each layer of the tungsten oxide layer 4 and the catalyst activity promoting layer 5 is not particularly limited, either.

To exhibit sufficient hydrophilicity, thickness of the tungsten oxide layer 4 is preferably 10 nm or more. Although the hydrophilicity is improved as the tungsten oxide layer 4 becomes thicker, the transparency is lowered by coloration as the thickness increases. As such, the upper limit of the thickness of the tungsten oxide layer can be adjusted by considering the properties such as hydrophilicity, transparency, and reflectance that are required for the tungsten oxide layer 4, and the cost.

For example, when the hydrophilic member 10 is applied to a wind shield of an automobile, it is preferable to have the reflectance equivalent to that of a glass as a substrate to prevent image projection or the like. From this point of view, thickness of the tungsten oxide layer is preferably 20 nm or less.

Fig. 2 is a drawing illustrating the relation between thickness of the tungsten oxide layer and reflectance thereof. The tungsten oxide layer is a WO₃ film which has been formed by sputtering on a substrate with SiO₂ film formed thereon (soda glass) and calcined for 2 hours at 500°C. Further, the reflectance indicates a reflectance at 60°, which has been measured in view of JISR 3106-1985 by using U-4000 (manufactured by Hitachi, Ltd.) and obtained after weighting based on visible sensitivity in the wavelength range of 380 to 780 nm. From Fig. 2, it is found that, when the thickness of the tungsten oxide layer is 20 nm or less, the reflectance was hardly changed compared to a case of not forming the tungsten oxide layer (a case in which the film thickness = 0).

Thickness of the catalyst activity promoting layer 5 is preferably 0.5 nm or more from the viewpoint of improving the hydrophilicity. Meanwhile, the thickness is preferably 1 µm or less. From the viewpoint of the transparency, it is more preferably 10 nm or less. From the viewpoint of preventing coloration by inhibiting light absorption, it is even more preferably 2 nm or less.

Meanwhile, for a case in which thickness of the catalyst activity promoting layer is very thin, for example, 2 nm or less, it is difficult to have the catalyst activity promoting agent evenly distributed on the entire surface of the intermediate layer or the tungsten oxide layer that is present underneath it (Fig. 1B and Fig. 1E). In such a case, a structure in which the catalyst activity promoting agent is present in a patchy (stripe) shape, that is, a structure in which the catalyst activity promoting agent is partially present on top of the intermediate layer or the tungsten oxide layer, is generally formed (for example, Fig. 1A, Fig. 1C, Fig. 1D, Fig. 1F, and Fig. 1I).

It is possible for the catalyst activity promoting layer 5 to be formed on an entire top surface of the intermediate layer 2 or the tungsten oxide layer 4 (Fig. 1B and Fig. 1E). However, from the viewpoint of maintaining the transparency of a hydrophilic member, it is preferable that the catalyst activity promoting layer 5 is partially formed on the top surface of the intermediate layer 2 or the tungsten oxide layer 4 (Fig. 1A, Fig. 1C, Fig. 1D, Fig. 1F, and Fig. 1I). More preferably, it is a structure in which the catalyst activity promoting agent is distributed on the top surface of the intermediate layer 2 or the tungsten oxide layer 4 in a patchy (stripe) shape. Meanwhile, the partially formed catalyst activity promoting layer 5 may be arranged either regularly or irregularly on the top surface of the intermediate layer 2 or the tungsten oxide layer 4. Further, the cross-sectional shape of the partially formed catalyst activity promoting layer 5 (a cross-section perpendicular to the lamination direction of the photocatalyst layer) is not particularly limited, either. It may have any shape such as a circular shape, an elliptical shape, a square shape, a rectangular shape, a approximate circular shape, a polygonal shape, or a indefinite shape.

### (Tungsten oxide)

Tungsten oxide is not particularly limited as long as it can exhibit a photocatalytic activity by visible light with wavelength of 380 nm or higher. For example, WOₙ (2 ≤ n ≤ 3) such as WO₂, WO_{2.72}, or WO_{2.96} can be used, and from the viewpoint of exhibiting a higher hydrophilic property, WO₃ is preferably used.

Structure of the tungsten oxide is not particularly limited, and it may have an amorphous structure or a crystal structure. Examples of the crystal structure of WO₃ include a cubic structure (tetragonal), a monoclinic structure (monoclinic), and a hexagonal structure (hexagonal). Among them, the monoclinic structure having a high photocatalytic activity is preferable. Since WO₃ with a monoclinic structure has a high photocatalytic activity, it can easily degrade an organic material adhered on a surface, and accordingly, it can significantly increase the hydrophilicity. Meanwhile, tungsten oxide (WO₃) formed as a film and calcined on an intermediate layer consisting of SiO₂, TiO₂, Al₂O₃, or SnO₂ has a monoclinic structure (monoclinic), and it can exhibit an excellent photocatalytic activity.

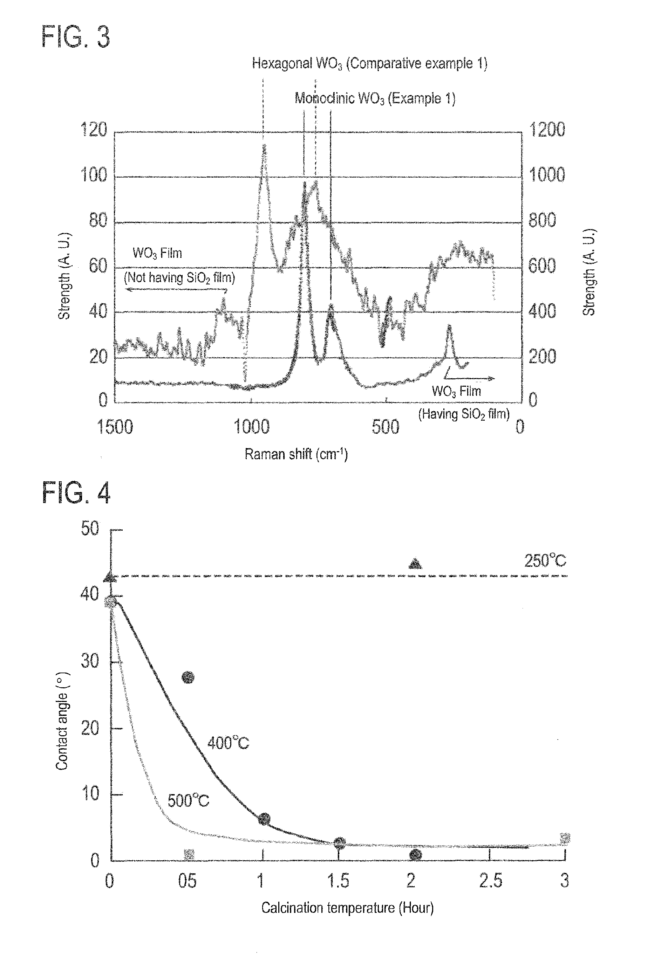

Crystal structure of WO₃ can be determined by Raman spectrum measurement. Herein, the Raman spectrum of the hydrophilic member obtained from Example 1 and Comparative Example 1 that are described below is illustrated in Fig. 3. As illustrated in Fig. 3, WO₃ having a monoclinic structure (monoclinic) has each of a peak near 808 cm⁻¹ derived from W=O group and a peak near 718 cm⁻¹ derived from O-W-O group. Meanwhile, the WO₃ having a hexagonal structure (hexagonal) has a peak near 950 cm⁻¹ derived from W=O group and a peak near 770 cm⁻¹ derived from O-W-O group. The WO₃ having a hexagonal structure (hexagonal) is formed by, for example, forming a WO₃ film directly on a substrate and calcining it.

Content of tungsten oxide among the materials constituting the photocatalyst layer is preferably 50% by mass or more, more preferably 80% by mass or more, even more preferably 90% by mass or more, and particularly preferably 100% by mass in order to have sufficiently exhibited hydrophilicity effect.

### (Catalyst activity promoting agent)

It is preferable that the photocatalyst layer 3 further contains a catalyst activity promoting agent in addition to tungsten oxide. The catalyst activity promoting agent indicates those capable of supplementing the photocatalytic action of tungsten oxide and promoting the photocatalytic action. When the photocatalyst layer 3 contains a catalyst activity promoting agent, a decrease in the hydrophilicity caused by adhesion of organic materials on a surface of the photocatalyst layer can be prevented by the effect of promoting the photocatalytic activity, and thus the hydrophilicity can be maintained stably at a high level.

Although the detailed mechanism of promoting the photocatalytic activity by the catalyst activity promoting agent remains unclear, it is presumed as follows. The photocatalytic action includes generation of a hole by excitation of electrons in a valence band of tungsten oxide to a conduction band as caused by visible light and oxidation of an organic substance such as aldehydes or carboxylic acids by OH radicals that are produced by reaction between the hole and water. In case of containing tungsten oxide only, the level of the conduction band is lower compared to the reduction level of oxygen (O₂), and thus the excited electrons are not consumed. On the other hand, in the case of containing the catalyst activity promoting agent, electrons are further excited by visible light so that it can have higher level than the reduction level of oxygen, and as a result, the electrons are consumed and the photodegradation of organic substances can easily occur.

Meanwhile, in the case of containing the catalyst activity promoting agent, it is preferable that visible light be irradiated on both of tungsten oxide and the catalyst activity promoting agent. However, a desired photocatalytic activity can be obtained even without directly irradiating light on the catalyst activity promoting agent.

Examples of the catalyst activity promoting agent include a compound of transition metal or a single substance of noble metal. As a transition metal, copper or iron can be used. Examples of the copper compound include copper oxide such as Cu₂O or CuO; copper nitrate such as CuNO₃ or Cu(NO₃)₂; copper sulfate such as Cu₂SO₄ or CuSO₄; copper sulfide such as Cu₂S and CuS; copper chloride such as Cu₂Cl and CuCl; and a hydrate thereof (for example, Cu(NO₃)₂·3H₂O and CuSO₄·5H₂O). Examples of the iron compound include iron oxide such as Fe₃O₄, FeO, or Fe₂O₃; iron oxyhydroxide such as FeOOH; iron hydroxide such as Fe(OH)₂ or Fe(OH)₃; iron nitrate such as Fe(NO₃)₂ or Fe(NO₃)₃; iron sulfate such as FeSO₄ or Fe₂(SO₄)₃; iron sulfide such as FeS, Fe₂S₃, or FeS₂; iron chloride such as FeCl₂ or FeCl₃; and a hydrate thereof. Examples of the noble metal include at least one selected from Pt, Rh, Pd, and Ag. They may be used either singly or in combination of two or more types.

For improving the hydrophilic property, it is preferably a compound of transition metal. For further improving the photocatalytic action and also further enhancing the hydrophilic property, it is more preferably a copper compound. From the viewpoint of low cost, it is even more preferably at least one of copper oxide, copper nitrate, and copper sulfate. It is particularly preferably CuO with the lowest cost. Meanwhile, when an iron compound is used, iron oxide, in particular Fe₃O₄, is preferably used for improving the hydrophilic property.

Use amount of the catalyst activity promoting agent is not particularly limited, if it is an amount allowing effective expression of the catalytic activity promoting mechanism of a photocatalyst. In general, it can be used in a range of 0.01 to 50% by mass relative to 100% by mass of tungsten oxide. It can be suitably adjusted depending on a type and a mode of combined use of the catalyst activity promoting agent. Within the above range, tungsten oxide and the catalyst activity promoting agent can function in a cooperative manner, and thus a photocatalyst having excellent photocatalytic characteristics and hydrophilic characteristics is obtained.

Meanwhile, when a catalyst activity promoting agent having excellent light absorption characteristics is used, for example, a copper compound is used as the catalyst activity promoting agent, a caution needs to be taken regarding the upper limit of the addition amount such that the photodegradation reaction is not suppressed by a copper compound which prevents light absorption of tungsten oxide. Specifically, the addition amount of the copper compound is preferably 5% by mass or less, and more preferably 1 to 2% by mass relative to tungsten oxide. Within the above range, the photodegradation reaction can be quickly progressed without preventing the light absorption of tungsten oxide by a copper compound.

### (Other additives)

The photocatalyst layer 3 of the present invention may contain other additives in addition to tungsten oxide and the catalyst activity promoting agent within a range that the hydrophilic property and the photocatalytic property are not impaired. Examples of the additives include, for the purpose of enhancing coatability, film strength, and a designing property, a surfactant, a leveling agent, an anti-foaming agent, a stabilizing agent, a thickening agent, a binding agent, a conductive agent, a pigment, a photostabilizing agent, a glazing agent, a matting agent, an anti-static agent, a buffering agent, and a dispersion agent.

### (Method for producing hydrophilic member)

According to another embodiment of the present invention, a method for producing a hydrophilic member is provided. The production method includes a step of forming a first intermediate layer containing a metal oxide on a substrate, a step of forming a coating film containing tungsten oxide on the first intermediate layer, and a step of forming a photocatalyst layer by calcining the coating film at 400°C or higher. According to the production method of the present embodiment, by forming a film of a photocatalyst layer containing tungsten oxide on the first intermediate layer and calcining (heating) it at a pre-determined temperature, the photocatalyst layer becomes a dense layer having excellent mechanical strength, and thus the durability can be enhanced.

In particular, the inventors of the present invention found that a WO₃ film formed · calcined on an intermediate layer consisting of SiO₂, TiO₂, Al₂O₃, or SnO₂ has a monoclinic structure (monoclinic), and also found that high hydrophilicity is exhibited accordingly.

### (1) Step for forming first intermediate layer

First, the first intermediate layer containing a metal oxide is formed (film formation) on a substrate.

Further, when a hydrophilic member having a second intermediate layer is produced as illustrated in Fig. 1I, the second intermediate layer is formed (film formation) on top of the first intermediate layer.

### (2) Step for forming photocatalytic coating film

Next, a coating film containing tungsten oxide is formed (film formation) on top of the intermediate layer (first intermediate layer or second intermediate layer).

Meanwhile, when the photocatalyst layer contains a catalyst activity promoting agent, for example, a photocatalyst layer having a bilayer form illustrated in Figs. 1A to 1F, and Fig. 1I is formed, a coating film containing tungsten oxide is formed in the lamination order of the tungsten oxide layer 4 and the catalyst activity promoting layer 5.

For example, when the catalyst activity promoting layer 5 is disposed under the tungsten oxide layer 4 as illustrated in Figs. 1A to 1C, and Fig. 1I, the catalyst activity promoting layer 5 containing a catalyst activity promoting agent is formed by a film formation method described below on top of the intermediate layer 2. Further, on top of the catalyst activity promoting layer 5, a coating film containing tungsten oxide is formed (film formation) .

When the catalyst activity promoting layer 5 is disposed on top of the tungsten oxide layer 4 as illustrated in Figs. 1D to 1E, a coating film containing tungsten oxide is formed (film formation) on top of the intermediate layer 2 first. After that, either before or after the calcining step described below, the catalyst activity promoting layer 5 containing a catalyst activity promoting agent is formed (film formation) on top of the coating film of tungsten oxide or the tungsten oxide layer 4. Further, for a case in which the tungsten oxide layer or the catalytic activity promoting layer is partially formed as illustrated in Fig. 1A, Fig. 1C, Fig. 1D, Fig. 1F, or Fig. 1I or a case in which irregularities are formed on a surface as illustrated in Fig. 1H, a coating film having desired pattern can be formed by using a mask pattern.

Alternatively, when the photocatalyst layer has a monolayer structure containing tungsten oxide and a catalyst activity promoting agent, it is possible that a coating film containing tungsten oxide and a catalyst activity promoting agent is formed (film formation) followed by calcining step described below.

The coating film containing tungsten oxide that is formed in the present step is calcined in the step described below. It is unnecessary to perform calcination after film formation of the catalyst activity promoting agent or film formation of metal oxide, and the coating film containing the catalyst activity promoting agent or the coating film containing metal oxide that has been formed by the following film forming method can be used directly as the catalyst activity promoting layer 5 or the intermediate layer 2.

### (Film formation method for intermediate layerjphotocatalyst coating film)

Film formation method is not particularly limited, and any conventionally known method can be used. Examples of the method that can be used include a sputtering method such as magnetron sputtering, unbalanced magnetron sputtering (UBMS), or dual magnetron sputtering, an ion plating method such as arc ion plating, a dry method such as chemical deposition method (CVD), and a wet method such as spin coating, dip coating, spray coating, a sol-gel method, or a doctor blade method.

### 1. Dry method

The dry method has advantages that, as the film formation can be achieved at relatively low temperature, damages on a base below film such as a substrate can be suppressed at a minimum level. Among the dry methods, it is particularly preferable to use a sputtering method. The sputtering method is advantageous in that it is useful for forming an even and transparent film having high strength and also film quality of a layer to be formed can be controlled by controlling bias voltage or the like. Further, by controlling a condition for sputtering including sputtering rate, dispersion state of particles can be controlled.

When a sputtering method is used, a compound capable of producing materials for constituting each layer (metal oxide, tungsten oxide, and a catalyst activity promoting agent) can be used as a target. When a mixture layer having plural materials is used, a mixed film can be formed by simultaneous sputtering using plural targets.

For example, when the intermediate layer (first intermediate layer, second intermediate layer) is formed by using SiO₂ as a metal oxide, it is preferable to use an Si target or an SiO₂ target.

As for the target material of tungsten oxide, it is preferable to use a W (metal tungsten) target or a WO₃ target. By using these target materials, a tungsten oxide thin film having high photocatalytic activity is obtained. More preferably, a WO₃ target is used. When W (metal tungsten) is used as a target material, it is necessary to heat the substrate during sputtering for making it to be visible light-responsive (see, Patent Document 1). The substrate temperature is, from the viewpoint of not having crystallization of tungsten oxide at high level and obtaining a desired structure of tungsten oxide, preferably 200 to 400°C. Meanwhile, as heating of a sputtering substrate is unnecessary when a WO₃ target is used, production can be achieved at low cost.

Further, when a mixed film of SiO₂ and WO₃ is formed, simultaneous sputtering can be performed by using an Si target or an SiO₂ target and a W (metal tungsten) target or a WO₃ target.

As for the target for the catalyst activity promoting agent, a single substance of noble metal, a transition metal compound, or a compound capable of producing a transition metal compound can be used. For example, when a copper compound is contained as a catalyst activity promoting agent, it is preferable to use, from the viewpoint of cost, a Cu target or a CuO target which is universally used. It is more preferable to use a CuO target. For a case in which other additives are contained or a case in which a different layer such as a layer for preventing deterioration of a substrate surface or the like is contained, sputtering can be performed by using a target which can form a subject material.

As an atmosphere for sputtering, for example, air, oxygen, inert gas (nitrogen, helium, argon, or the like) containing oxygen or vacuum can be used. Among them, air is preferable as it can be used at low cost. Meanwhile, when a W (metal tungsten) target is used, it is necessary to introduce a reactive gas containing oxygen in addition to inert gas. When inert gas containing oxygen is used, an oxygen ratio in atmosphere gas is preferably 10% or more. When a WO₃ target is used, a trace amount of oxygen gas is preferably added. Concentration of oxygen gas is preferably about 10% to 30%. When an SiO₂ target is used, it is preferable to perform the sputtering in vacuum.

Condition for sputtering is not particularly limited if it is a condition allowing the formation of a desired film. As the condition for sputtering varies depending on a sputtering apparatus, it is preferable to know in advance a preferred range via a pre-experiment or the like.

### 2. Wet method

Meanwhile, as the wet method requires no large-scale device in addition to having easy control of film thickness or structure, it is advantageous from the viewpoint of having low cost and excellent large-scale production. Specific examples of the method include the following methods (a) and (b).
(a) A method of forming an intermediate layer (first intermediate layer, second intermediate layer) or a photocatalyst coating film (tungsten oxide coating film, catalyst activity promoting layer, and mixed coating film) by using a dispersion of metal oxide powder or a dispersion of tungsten oxide powder or powder of catalyst activity promoting agent.
(b) A method of forming an intermediate layer (first intermediate layer, second intermediate layer) or a photocatalyst coating film (tungsten oxide coating film, catalyst activity promoting layer, mixed coating film) by using an aqueous solution of precursor ions of metal oxide or an aqueous solution of tungsten ions or precursor ions of a catalyst activity promoting agent (aqueous precursor solution).

### Hereinbelow, each method is explained.

### Method (a)

When a dispersion of microparticles (metal oxide powder, tungsten oxide powder, and powder of catalyst activating agent) is used, particles previously controlled to a desired particle diameter (microparticles of metal oxide, microparticles of tungsten oxide or catalyst activity promoting agent, and supported body) can be used. Accordingly, the particle diameter can be easily controlled, and it is preferred from the viewpoint of having easy forecast of the performance of a layer to be obtained. Meanwhile, when powder of tungsten oxide already having crystallinity is used, the calcining step may not be performed after film formation. Using an aqueous solution of precursor ions is preferable in that the film thickness or structure can be easily controlled. Meanwhile, when powder of tungsten oxide already having crystallinity is used, the adhesion to a substrate is weak, and thus there are many cases of having a problem in durability and anti-abrasiveness.

A method for producing a supported body by supporting a catalyst activity promoting agent (fine powder) on tungsten oxide powder is not particularly limited. For example, the production can be made by adding and mixing tungsten oxide (WO₃) powder in an aqueous solution or an ethanol solution of a catalyst activity promoting agent such as copper sulfate or copper nitrate, and drying at 70 to 80°C followed by calcining at 500 to 550°C. Meanwhile, the optimum condition for supporting a catalyst activity promoting agent on tungsten oxide is suitably determined in consideration of type, shape, and support amount of the catalyst activity promoting agent. For example, when powder of a catalyst promoting activating agent has a small particle diameter and large surface area, the optimum addition amount also tends to decrease. In case of CuO powder, commercially available CuO powder has a large particle diameter and relatively small surface area. However, CuO powder synthesized by wet and low temperature condition or CuO supported by impregnation supporting method at low temperature has ultra-microparticles with large surface area, and thus, the required addition amount can be also reduced. When prepared in a supported body, tungsten oxide and the catalyst activity promoting agent are present very close to each other, and thus there are advantages that a large catalyst activity promoting effect is expected, and as the catalyst activity promoting agent is homogeneously dispersed, light absorption by tungsten oxide is hardly interfered.

In case of using a dispersion liquid, a dispersion liquid (dispersion liquid of a metal oxide, dispersion liquid of tungsten oxide, a mixed dispersion liquid of a metal oxide and tungsten oxide, dispersion liquid of a catalyst activity promoting agent, or a mixed dispersion liquid of tungsten oxide and a catalyst activity promoting agent) in which microparticles (powder of metal oxide and/or powder of tungsten oxide, powder of catalyst activating agent) are dispersed in a solvent is prepared. Specifically, by adding the microparticles to a solvent and stirring them with a suitable dispersion device (for example, a homogenizer, an ultrasonic dispersion device, a sand mill, a jet mill, a bead mill, or the like), a dispersion liquid is obtained.

As for the microparticles (powder of metal oxide, powder of tungsten oxide, powder of catalyst activating agent), a commercially available product can be used or those produced by a known method can be also used. As for the dispersion medium which can be used, it is most preferable to use water. However, for improving the dispersability, it is preferable to add alcohols such as methanol, ethanol, 1-propanol, or 2-propanol to water or to add a surfactant. A solid content concentration in the microparticles (metal oxide, tungsten oxide, a catalyst activating agent) in a dispersion liquid and a use amount of the alcohols or surfactant are not particular limited, and they can be suitably adjusted to achieve homogeneous coating.

Subsequently, the aforementioned dispersion liquid is coated to have a desired density (porous structure) or thickness by using a method such as spin coating, dip coating, spray coating, sol-gel method, or doctor-blade method. Then, as the solvent is removed by drying it, an intermediate layer containing a metal oxide and a photocatalyst coating film containing tungsten oxide and/or a catalyst activity promoting agent are produced.

Means for drying the coating film is not particularly limited, and conventionally known knowledge can be suitably referenced. Preferred examples include a dryer or heating furnace of conduction heating type, a radiation heating type, a hot air heating type, and a dielectric heating type. Specific examples include a dryer or a heating furnace of a belt type, an agitated through type, a screw type, a rotation type, a disc type, a kneader type, a fluid bed type, an air stream type, an infrared ray type, or an electronic beam type. The drying condition (for example, drying time, drying temperature, or the like) can be suitably set depending on the coating amount of a dispersion liquid or volatilization speed of a solvent.

### Method (b)

When using an aqueous precursor solution, an aqueous solution of precursor ions of a metal oxide, an aqueous solution of tungsten ions, or an aqueous solution of precursor ions of a catalyst activity promoting agent are prepared first.

The aqueous solution of precursor ions of a metal oxide is not particularly limited as long as it can produce a metal oxide. For example, when SiO₂ is used as a metal oxide, for example, an aqueous solution of Si(OC₂H₅)₄ (TEOS) or the like can be exemplified.

The aqueous solution of tungsten ions is not particularly limited as long as it can produce tungsten oxide. Examples thereof include an aqueous solution of tungstenic acid (H₂WO₄) and an aqueous solution of peroxotungstenic acid ((WO₂(O₂)H₂O)·nH₂O). From the viewpoint of having easy film formation, an aqueous solution of tungstenic acid is used. The concentration of tungsten ions can be suitably adjusted depending on type of an aqueous solution to be used, and it is preferably 5 to 50% by mass. When an aqueous solution of tungstenic acid is used, to prevent aggregation of tungsten oxide and to have a coating film with excellent transparency, a stabilizing agent such as polyethylene glycol (PEG), glycerol, mannitol, or ethylene glycol may be added. The addition amount of the stabilizing agent is, although not particularly limited, for example, 0.5 mass/mass in terms of the ratio of tungsten oxide/stabilizing agent.

The precursor ions of a catalyst activity promoting agent are not particularly limited if they can produce a catalyst activity promoting agent. When a copper compound is used as a catalyst activity promoting agent, for example, an aqueous solution of copper nitrate or an aqueous solution of copper sulfate can be preferably used. Their ion concentration is preferably 5 to 50% by mass.

Subsequently, the aforementioned aqueous precursor solution is coated on the substrate so as to have a desired density (porous structure) or thickness by using a method such as spin coating, dip coating, spray coating, sol-gel method, or doctor-blade method. Further, according to calcination, an intermediate layer and a photocatalyst coating film are formed. Means for calcining a coating film is not particularly limited, and conventionally known knowledge can be suitably referenced.

The calcination condition (for example, calcination time, calcination temperature, or the like) can be suitably set depending on the type, concentration, or a coating amount of an aqueous precursor solution. For example, when using an aqueous solution of tungstenic acid, the calcination temperature is preferably 100 to 400°C. Although the calcination time varies depending on an apparatus to be used or a desired film thickness, it is preferably 30 minutes or longer. When it is 30 minutes or longer, the structure of tungsten oxide can be stabilized. For example, it is 30 minutes or longer at 390°C. The upper limit for calcination time is not particularly limited, but it can be 24 hours or shorter, for example. Further, the same condition might be needed for a case in which an aqueous solution of peroxotungstenic acid is used. The calcination atmosphere is not particularly limited, either. Air is commonly used. However, inert gas (nitrogen, helium, argon, or the like), oxygen, or gas containing oxygen such as oxygen-enriched air can be also used.

When a mixed film containing tungsten oxide and a metal oxide is formed, a dispersion in which both tungsten oxide powder and metal oxide powder are dispersed or an aqueous solution in which both tungsten ions and precursor ions of a catalyst activity promoting agent are dissolved can be used for the above methods. Further, when tungsten oxide supported with a catalyst activity promoting agent is used, it is sufficient that particles of a support body are prepared in advance according to the above methods and a film is formed by using a dispersion liquid containing the particles of a supported body.

When a mixed film containing tungsten oxide and a catalyst activity promoting agent is formed, a dispersion in which both tungsten oxide powder and catalyst activity promoting agent are dispersed or an aqueous solution in which both tungsten ions and tungsten ions are dissolved can be used for the above methods.

For a case in which other additive are contained or a case in which a different layer such as a layer for preventing deterioration of a substrate surface is contained, the film formation can be achieved by coating a dispersion liquid or an aqueous solution containing the single subject material or a dispersion liquid or an aqueous solution of microparticles (metal oxide, tungsten oxide, a catalyst activity promoting agent) admixed with the subject material.

Methods for forming an intermediate layer (first intermediate layer, second intermediate layer), a catalyst activity promoting agent layer, a tungsten oxide film, and a mixed film can be the same or different from each other. However, from the viewpoint of easy operation, the same method is preferable. In particular, when sputtering is employed, continuous film formation can be achieved only by changing a target, and therefore it is preferably carried out by the same method.

### (3) Calcining (heating) step

Next, by calcining (heating) a photocatalyst coating film containing tungsten oxide obtained from the above step at 400°C or higher, the photocatalyst layer 3 is formed. According to the calcining step, tungsten oxide in an amorphous state is crystallized and the dense photocatalyst layer 3 is formed on top of the intermediate layer 2. When the photocatalyst layer 3 is composed of the tungsten oxide layer 4 and the catalyst activity promoting layer 5, the calcining step may be performed before forming the catalyst activity promoting layer 5 or after forming the catalyst activity promoting layer 5.

When a WO₃ film is formed on top of the intermediate layer 2 consisting of SiO₂, TiO₂, Al₂O₃, or SnO₂, WO₃ having a monoclinic structure (monoclinic) is obtained by the calcining step, and even higher hydrophilicity can be exhibited accordingly. On the other hand, when a tungsten oxide film (WO₃ film) is directly formed on a substrate as described in a related art (for example, the method described in Patent Document 1) followed by calcining, a WO₃ film having a hexagonal structure is obtained. The WO₃ film of Comparative Example 1, which has been directly formed on a substrate and calcined, has the hexagonal structure as illustrated in Fig. 3. However, the WO₃ film of Example 1, which has been formed on SiO₂ as an intermediate layer and calcined, has a monoclinic structure.

In order to have a dense crystal structure of tungsten oxide, the calcination temperature needs to be at least 400°C. When it is lower than 400°C, tungsten oxide is in an amorphous state and a dense crystal structure of tungsten oxide is not obtained, and thus poor durability may be yielded.

The upper limit of the calcination temperature is not particularly limited, but it is preferably 900°C or lower. When it is higher than 900°C, there is a only a limited usable substrate and a means for calcination is limited, and therefore unfavorable in terms of cost.

For obtaining a good crystal structure of tungsten oxide within a short time, the calcination temperature is preferably set at 500 to 800°C.

The calcination time is suitably determined depending on the calcination temperature. Fig. 4 is a drawing illustrating the relation between time for calcining the tungsten oxide film and contact angle on a surface of the tungsten oxide film after the calcination. Herein, the tungsten oxide film was formed by a sputtering on top of SiO₂ layer as an intermediate layer, and the contact angle was measured by the same method as described in Examples.

As illustrated in Fig. 4, calcination time needs to be 90 minutes or longer if the calcination time is 400°C or higher. When the calcination time is 500°C or higher, the calcination time of 30 minutes or longer is sufficient. Meanwhile, the upper limit of the calcination time is not particularly limited, either, and it is 24 hours or shorter, for example.

Means for calcination (heating) is not particularly limited, and conventionally known dryer or heating furnace is used. Preferred examples include a dryer or heating furnace of conduction heating type, a radiation heating type, a hot air heating type, and a dielectric heating type. Specific examples include a dryer or a heating furnace of a belt type, an agitated through type, a screw type, a rotation type, a disc type, a kneader type, a fluid bed type, an air stream type, an infrared ray type, or an electronic beam type.

The calcination atmosphere is not particularly limited, either. Air is commonly used as it is favorable in terms of cost. However, inert gas (nitrogen, helium, argon, or the like), oxygen, or gas containing oxygen such as oxygen-enriched air can be also used.

Meanwhile, the calcining step is not essentially required for the catalyst activity promoting layer and the intermediate layer as described above. However, for obtaining a strong structure, calcination may be carried out after forming a coating film of the catalyst activity promoting agent or a coating film of a metal oxide. For such case, the calcination condition may be 30 minutes to 24 hours at 400°C or higher, although it is not particularly limited. Further, when copper nitrate or copper sulfate is used as a catalyst activity promoting agent, copper oxide (CuO) film can be formed by calcining at high temperature following the film formation.

The hydrophilic member 10 of the present embodiment can be used for various applications. For example, it can be used for glass, mirror, tile, natural stone, concrete, a sign board, a coating base, or the like of an automobile, an electric car, an airplane, a ship, or a building. Further, for an automobile, it can be preferably used for any glass used for a wind shield, a front door, a rear door, or a rear parcel.

In particular, since the hydrophilic member 10 is equipped with a visible ray responsive photocatalyst layer, even under an environment like an inside of an automobile having an irradiation from a light source that consists of mostly visible rays like fluorescent light and weak ultraviolet rays, a sufficient environment purifying activity can be obtained.

### Examples

Hereinbelow, the effect of the present invention is explained by way of the following Examples and Comparative Examples, but the technical scope of the present invention is not limited to those examples.

### [Example 1]

### (1) Step for forming first intermediate layer

Soda glass (green glass) (thickness: 2 mm) for a wind shield of an automobile was prepared as a substrate. On the soda glass, a SiO₂ film (thickness: 50 nm) was formed as an intermediate layer by using a magnetron sputtering method (apparatus: type SRV-4300 manufactured by Shinko Seiki Co., Ltd). At that time, a SiO₂ disc was used as a target and the sputtering was performed in vacuum according to the following conditions: distance between the substrate and target; 100 mm, pressure; 5 x 10⁻⁴ Pa, film forming rate; 3 nm/minute, input power; 100 W, and substrate temperature; 25°C.

### (2) Step for forming photocatalyst coating film

### (a) Forming catalyst activity promoting agent film (forming a catalyst activity promoting layer)

On the SiO₂ film, a CuO film (thickness: 0.5 nm) was formed by continuous sputtering using a magnetron sputtering method (apparatus: type SRV-4300 manufactured by Shinko Seiki Co., Ltd). At that time, the sputtering was performed with the same conditions as those for forming the intermediate layer (SiO₂ film) except that a CuO disc is used as a target. Meanwhile, the CuO film has a structure that is distributed in patchy (stripe) shape on a SiO₂ film.

### (b) Forming tungsten oxide film

On the CuO film, a WO₃ film (thickness: 20 nm) was formed. At that time, the sputtering was performed with the same conditions as those for forming the intermediate layer (SiO₂ film) except that a WO₃ disc is used as a target and Ar atmosphere with oxygen ratio of 20% is used.

Accordingly, a coating film in which a CuO film and a WO₃ film are laminated in the order on top of a SiO₂ film was obtained.

### (3) Calcining step

Next, the obtained member was placed in a dryer and calcined for 2 hours at 500°C under air atmosphere. Accordingly, a member for evaluation having a photocatalyst layer, that is yielded by laminating a first intermediate layer (SiO₂ film), a catalyst activity promoting layer (CuO film), and a tungsten oxide layer (WO₃ film) on a substrate, was obtained (the hydrophilic member having a configuration illustrated in Fig. 1A).

### [Example 2]

A member for evaluation was obtained in the same manner as Example 1 except that the thickness of a SiO₂ film was 20 nm.

### [Example 3]

A member for evaluation was obtained in the same manner as Example 1 except that the thickness of a SiO₂ film was 100 nm.

### [Example 4]

A member for evaluation was obtained in the same manner as Example 1 except that the thickness of a WO₃ film was 10 nm.

### [Example 5]

On top of a SiO₂ film, a WO₃ film was formed, and then a CuO film was formed on top of the WO₃ film. Specifically, the lamination order of the CuO film and the WO₃ film in Example 1 was changed. Other than that, a member for evaluation was obtained in the same manner as Example 1 (the hydrophilic member having a configuration illustrated in Fig. 1D).

### [Example 6]

The CuO film was not formed. In other words, only the WO₃ film was formed on top of the SiO₂ film. Other than that, a member for evaluation was obtained in the same manner as Example 1 (the hydrophilic member having a configuration illustrated in Fig. 1G).

### [Example 7]

### (1) Step for forming first intermediate layer

Soda glass (green glass) (thickness: 2 mm) for a wind shield of an automobile was prepared as a substrate. On the soda glass, a 10% by mass aqueous solution of SiO₂ was coated by using a spin coater. After drying and calcining for 30 minutes at 500°C, a SiO₂ film (thickness: 1000 nm) was formed as an intermediate layer. At that time, conditions for spin coating include 15 seconds at 200 rpm.

### (2) Forming photocatalyst layer

### (a) Forming tungsten oxide layer

### (a-1) Forming tungsten oxide film (step for forming coating film)

On a SiO₂ film, a 20% by mass aqueous solution of tungstenic acid (H₂WO₃) was coated by using a spin coater. At that time, conditions for spin coating include 15 seconds at 200 rpm. Meanwhile, as for the aqueous solution of tungstenic acid, an aqueous solution of Na₂WO₃ which has been subjected to ion exchange by using a proton exchange resin was used.

### (a-2) Calcining step

Next, by calcining for 30 minutes at 500°C, a WO₃ film (thickness: 1000 nm) was formed as a tungsten oxide layer.

### (b) Forming catalyst activity promoting layer

On a WO₃ film, a 10% by mass aqueous solution af CuO (20x water dilution of an aqueous solution of CuO, which is manufactured by SYMETRIX) was coated by using a spin coater and dried. At that time, conditions for spin coating include 15 seconds at 200 rpm. After that, according to calcination for 30 minutes at 500°C, a CuO film as a catalyst activity promoting layer was formed (thickness: 100 nm).

According to the above steps, a member for evaluation equipped with a photocatalyst layer, which has been yielded by laminating an intermediate layer (SiO₂ film), a tungsten oxide layer (WO₃ film), and a catalyst activity promoting layer (CuO film) on a substrate, was obtained (the hydrophilic member having a configuration illustrated in Fig. 1E).

### [Example 8]

### (1) Step for forming first intermediate layer

Soda glass (green glass) (thickness: 2 mm) for a wind shield of an automobile was prepared as a substrate. On the soda glass, a SiO₂ film (thickness: 50 nm) was formed as an intermediate layer by using a magnetron sputtering method (apparatus: type SRV-4300 manufactured by Shinko Seiki Co., Ltd). At that time, a SiO₂ disc was used as a target and the sputtering was performed in vacuum according to the following conditions: distance between the substrate and target; 100 mm, pressure; 5 × 10⁻⁴ Pa, film forming rate; 3 nm/minute, input power; 100 W, and substrate temperature; 25°C.

### (2) Step for forming second intermediate layer

On the SiO₂ film, a mixed film of WO₃ and SiO₂ (thickness: 10 nm, WO_{3 :} SiO₂ = 1 : 1 (volume ratio)) was formed by continuous co-sputtering of WO₃ and SiO₂ using a magnetron sputtering method (apparatus: type SRV-4300 manufactured by Shinko Seiki Co., Ltd.). At that time, the sputtering was performed with the same conditions as those for forming the first intermediate layer (SiO₂ film) except that a SiO₂ disc and a WO₃ disc were used as a target.

### (3) Step for forming photocatalyst coating film

### (a) Forming catalyst activity promoting agent film (forming a catalyst activity promoting layer)

On the mixed film of WO₃ and SiO₂, a CuO film (thickness: 0.5 nm) was formed by continuous sputtering using a magnetron sputtering method (apparatus: type SRV-4300 manufactured by Shinko Seiki Co., Ltd). At that time, the sputtering was performed with the same conditions as those for forming the first intermediate layer (SiO₂ film) except that a CuO disc is used as a target. Meanwhile, the CuO film has a structure having patchy (stripe) shape distribution on the mixed film.

### (b) Forming tungsten oxide film

On the CuO film, a WO₃ film (thickness: 15 nm) was formed. At that time, continuous sputtering was performed with the same conditions as those for forming the intermediate layer (SiO₂ film) except that a WO₃ disc is used as a target and an Ar atmosphere having oxygen ratio of 20% is used.

Accordingly, a coating film in which a mixed film of WO₃ and SiO₂, a CuO film, and WO₃ film are laminated in the order on top of a SiO₂ film was obtained.

### (4) Calcining step

Next, the obtained member was placed in a dryer and calcined for 2 hours at 500°C under air atmosphere. Accordingly, a member for evaluation having a photocatalyst layer, that is obtained by laminating a first intermediate layer (SiO₂ film), a second intermediate layer (mixed film of WO₃ and SiO₂), a catalyst activity promoting layer (CuO film), and a tungsten oxide layer (WO₃ film) on a substrate, was obtained (the hydrophilic member having a configuration illustrated in Fig. 1I).

### [Example 9]

A member for evaluation was obtained in the same manner as Example 8 except that the thickness of a SiO₂ film as a first intermediate layer is changed to 100 nm.

### [Comparative Example 1]

A member for evaluation was obtained in the same manner as Example 1 except that a SiOg film is not formed but a CuO film and a WO₃ film are formed in the order on a substrate.

### [Comparative Example 2]

A member for evaluation was obtained in the same manner as Example 4 except that a SiO₂ film and a CuO film are not formed but only a WO₃ film is formed on a substrate (the hydrophilic member having a configuration illustrated in Fig. 1E).

### [Comparative Example 3]

None of a SiO₂ film, a CuO film, and a WO₃ film was formed. In other words, the soda glass itself was used as a member for evaluation.

### [Evaluation]

### 1. SEM observation

Surface of a photocatalyst layer (tungsten oxide layer) of the member for evaluation, which has been prepared in the above Examples and Comparative Examples, was observed by using a scanning electron microscope (SEM; S-4000 manufactured by Hitachi, Ltd).

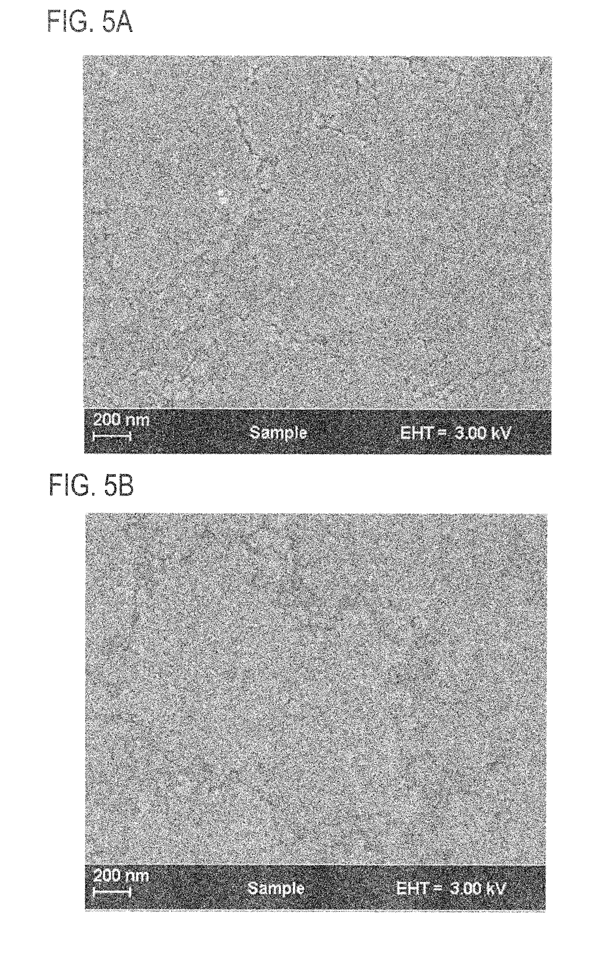

Figs. 5A to 5C illustrate SEM photographs of the surface of a photocatalyst layer of a member for evaluation that has been produced in Examples 1 and 2 and Comparative Example 1.

From Fig. 5A and Fig. 5B, it was confirmed that a dense film consisting of tungsten oxide is formed in the member for evaluation of Examples 1 and 2, which has an intermediate layer. In particular, it was found that the tungsten oxide layer of Example 1 in which thickness of SiO₂ is 50 nm or more has less formation of microparticles and better crystallinity compared to Example 2.

Further, a steel wool abrasion test (JIS H 0201 317: 1998) was performed for the surface of the tungsten oxide layer in the member for evaluation of Examples 1 and 2. After the test, the surface of the tungsten oxide layer was observed again by using a SEM (S-4000 manufactured by Hitachi, Ltd) . As a result, it was confirmed that almost no scratch has occurred. It was also confirmed by a naked eye that there is no abnormality. Based on the results, it was found that the dense layer of tungsten oxide in Examples 1 and 2 has a very strong structure.

Meanwhile, although it has not been illustrated, it was also found that the same dense and strong layer as that of Examples 1 and 2 is formed in the member for evaluation which has been produced in Examples 3 to 9.

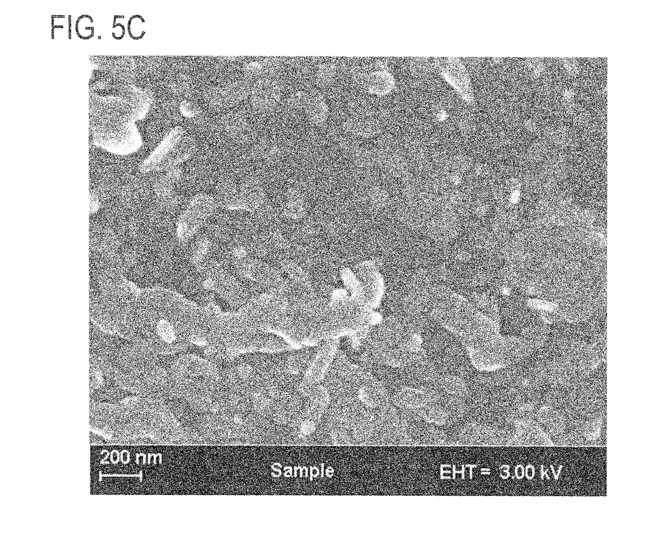

Meanwhile, as illustrated in Fig. 5C, as a result of performing a steel wool abrasion test, the member for evaluation of Comparative Example 1 not having an intermediate layer was found to have lots of scratches formed thereon. Thus, it was confirmed that it has a weak structure of which surface is easily peeled and disrupted.

### 2. Measurement of Raman spectrum

By using a dispersive type microscopic laser Raman spectroscopy analyzer (SENTERRA manufactured by Bruker Optics K. K.), the member for evaluation produced in Examples and Comparative Examples was subjected to a Raman spectrum measurement. Among them, the spectrum obtained for Example 1 and Comparative Example 1 is illustrated in Fig. 3.

It was found from Fig. 3 that a WO₃ film having monoclinic structure is formed in Example 1 having an intermediate layer (SiO₂ film). Meanwhile, also in other members for evaluation of Examples 2 to 9, it was found that a WO₃ film having monoclinic structure was formed, similar to Example 1.

Meanwhile, it was found from Fig. 3 that, in Comparative Example 1 having no intermediate layer, a WO₃ film with hexagonal structure was formed.

### 3. Measurement of contact angle

Contact angle of water on a surface of the photocatalyst layer of a member for evaluation produced in Examples and Comparative Examples was measured by θ/2 method by using an apparatus for measuring contact angle (FACE contact angle analyzer CA-X, manufactured by Kyowa Interface Science Co., LTD) . Meanwhile, the measurement was carried out indoors (atmospheric pressure, 25°C, and humidity of 50 to 60%). The results are shown in Table 1.

**[Table 1]**

| | Lamination structure on substrate (described orderly from the outermost surface side to the substrate side) | Method for forming film | Film structure | Contact angle (°) | | |
|---|---|---|---|---|---|---|
| | | | | Initial stage | After 4 days | Change in contact angle ⁽¹⁾ |
| Example 1 | WO₃ (20 nm) / CuO (0.5 nm) / SiO₂ (50 nm) | Sputtering | Dense | 2.2° | 4.5° | ○ |
| Example 2 | WO₃ (20 nm) / CuO (0.5 nm) / SiO₂ (20 nm) | Sputtering | Dense | 4.5° | 4.2° | ⊙ |
| Example 3 | WO₃ (20 nm) / CuO (0.5 nm) / SiO₂ (100 nm) | Sputtering | Dense | 1.5° | 4.5° | ○ |
| Example 4 | WO₃ (10 nm) / CuO (0.5 nm) / SiO₂ (50 nm) | Sputtering | Dense | 4.5° | 4.2° | ⊙ |
| Example 5 | CuO (0.5 nm) / WO₃ (20 nm) / SiO₂ (50 nm) | Sputtering | Dense | 4.5° | 7.0° | ○ |
| Example 6 | WO₃ (20 nm) / SiO₂ (20 nm) | Sputtering | Dense | 4.8° | 6.0° | ○ |
| Example 7 | CuO (100 nm) / WO₃ (1000 nm) / SiO₂ (1000 nm) | Spin coating | Dense | 6.1° | 7.4° | ○ |
| Example 8 | WO₃ (15 nm) / CuO (0.5 nm) / WO₃ : SiO₂ = 1 : 1 (10 nm) / SiO₂ (50 nm) | Sputtering | Dense | 3.3° | 3.5° | ⊙ |
| Example 9 | WO₃ (15 nm) / CuO (0.5 nm) / WO₃ : SiO₂ = 1 : 1 (10 nm) / SiO₂ (100 nm) | Sputtering | Dense | 2.4° | 3.0° | ○ |
| Comparative Example 1 | WO₃ (20 nm) / CuO (0.5 nm) | Sputtering | Weak | 4.2° | 17.2° | Δ |
| Comparative Example 2 | WO₃ (10 nm) | Sputtering | Weak | 7.0° | 35.6° | × |
| Comparative Example 3 | Blank | - | - | 40° | - | - |

| | | | | | | |
|---|---|---|---|---|---|---|
| (1) The change in contact angle represents a difference between the contact angle after 4 days and the contact angle at initial stage, and each of the symbols ⊙, ○, Δ, and × in the table indicates the followings. ⊙ ··· Change in contact angle is 0.5° or less, ○ ··· Change in contact angle is higher than 0.5° but the same or lower than 3.0°, Δ ··· Change in contact angle is higher than 3.0° but the same or higher than 10.0°, × ··· Change in contact angle is higher than 10.0° but the same or higher than 20.0°. | | | | | | |

As shown in the results of Table 1, it was confirmed that the member for evaluation of Examples in which the tungsten oxide layer (WO₃ film) is formed on top of the first intermediate layer (SiO₂ film) exhibited super-hydrophilicity, that is, both the initial contact angle and contact angle after 4 days are 7° or less, and the excellent hydrophilicity can be maintained for a long period of time (excellent durability).

Further, it was also confirmed that the hydrophilicity is further improved in Examples 1 to 6, 8, and 9 in which tungsten oxide is present on the outermost surface of the photocatalyst layer. Among them, when there is a catalyst activity promoting layer (CuO film) (Examples 1 to 5, 8, and 9), the hydrophilicity is significantly improved compared to Example 6 in which no CuO film is included. In particular, from Examples 1 to 4, 8, and 9 in which the catalyst activity promoting layer is present inside the photocatalyst layer and only tungsten oxide is present on the outermost surface of the photocatalyst layer (Fig. 1A), extremely excellent hydrophilicity showing contact angle of 5° or less even after 4 days was shown, and thus further improvement of the durability was confirmed. Meanwhile, in a case in which the second intermediate layer (a mixed film of WO₃ and SiO₂) is present between the first intermediate layer and the photocatalyst layer (Examples 8 and 9), a change in contact angle over time is also suppressed at low level in addition to excellent hydrophilicity due to low contact angle value.

Meanwhile, the member for evaluation of Comparative Examples in which no intermediate layer is included showed a significantly increased contact angle after 4 days compared to the member for evaluation of Examples. In particular, it was found that the member for evaluation of Comparative Example 1 showed super-hydrophilicity as the initial contact angle is suppressed at low level by having the catalyst activity promoting agent, but after 4 days, the contact angle increases so that the hydrophilic surface cannot be maintained. It is believed that dirt or organic substances in air adhere over the time on a surface of the member for evaluation of Comparative Examples, yielding lower contact angle.

Based on the above, it was confirmed that the photocatalyst layer of the present invention that is formed on top of the intermediate layer has a dense and strong structure, and a hydrophilic member with excellent durability that can maintain excellent hydrophilicity even when kept for a long period of time can be obtained.

### Description of the codes

- 1: Substrate
- 2: First intermediate layer
- 3: Photocatalyst layer
- 4: Tungsten oxide layer
- 5: Catalyst activity promoting layer
- 6: Second intermediate layer
- 10: Hydrophilic member

## Claims

1. A hydrophilic member comprising:
a substrate;
a first intermediate layer which is disposed on the substrate and contains a metal oxide that contains an element of Group 4, Group 6, Group 13 or Group 14 of the periodic table; and
a photocatalyst layer which is disposed on the first intermediate layer and contains tungsten oxide.

2. The hydrophilic member according to claim 1, further comprising a second intermediate layer which is disposed between the first intermediate layer and the photocatalyst layer and contains a metal oxide that contains an element of Group 4, Group 6, Group 13 or Group 14 of the periodic table, and tungsten oxide.

3. The hydrophilic member according to claim 1 or 2, wherein the photocatalyst layer further contains a catalyst activity promoting agent and the catalyst activity promoting agent is a compound of transition metal or a single substance of noble metal.

4. The hydrophilic member according to any one of claims 1 to 3, wherein the metal oxide contained in the first intermediate layer is at least one selected from a group consisting of silicon oxide, titan oxide, aluminum oxide, tin oxide, and tungsten oxide.

5. The hydrophilic member according to claim 2, wherein the metal oxide contained in the second intermediate layer is at least one selected from a group consisting of silicon oxide, titan oxide, aluminum oxide, and tin oxide.

6. The hydrophilic member according to any one of claims 1 to 5, wherein the structure of the tungsten oxide is WO₃.

7. The hydrophilic member according to claim 6, wherein the WO₃ has a monoclinic structure.

8. The hydrophilic member according to claim 3, wherein the catalyst activity promoting agent contains the compound of transition metal and the compound of transition metal is a copper compound.

9. The hydrophilic member according to claim 3 or 8, wherein the photocatalyst layer is obtained by laminating a tungsten oxide layer containing the tungsten oxide and a catalyst activity promoting layer containing the catalyst activity promoting agent and a thickness of the catalyst activity promoting agent is 2 nm or less.

10. The hydrophilic member according to claim 7, wherein a thickness of the tungsten oxide layer is 20 nm or less.

11. The hydrophilic member according to any one of claims 1 to 10, wherein the tungsten oxide is present on an outermost surface of the photocatalyst layer.

12. The hydrophilic member according to any one of claims 1 to 11, wherein a material for constituting the substrate is glass.

13. A method for producing a hydrophilic member comprising:
a step of forming a first intermediate layer containing a metal oxide on a substrate;
a step of forming a coating film containing tungsten oxide on the first intermediate layer; and
a step of forming a photocatalyst layer by calcining the coating film at 400°C or higher.
